(19) Europäisches Patentamt
European Patent Office
Office européen des brevets

(11) EP 4 541 858 A1

(12) **EUROPEAN PATENT APPLICATION**
published in accordance with Art. 153(4) EPC

(43) Date of publication:
**23.04.2025 Bulletin 2025/17**

(21) Application number: **23823997.4**

(22) Date of filing: **16.06.2023**

(51) International Patent Classification (IPC):
*C08L 83/07* (2006.01) *C08K 3/011* (2018.01) *C08K 3/013* (2018.01) *C08L 83/05* (2006.01) *C08L 83/06* (2006.01) *H01L 23/373* (2006.01)

(52) Cooperative Patent Classification (CPC):
**C08K 3/011; C08K 3/013; C08L 83/04; C08L 83/06; H01L 23/373**

(86) International application number:
**PCT/JP2023/022390**

(87) International publication number:
**WO 2023/243707 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.06.2022 JP 2022098432**

(71) Applicant: **SEKISUI CHEMICAL CO., LTD.**
**Osaka-shi**
**Osaka**
**530-8565 (JP)**

(72) Inventors:
- **INUI, Osamu**
**Mishima-gun, Osaka 618-0021 (JP)**
- **NISHIZAWA, Hidehito**
**Mishima-gun, Osaka 618-0021 (JP)**

(74) Representative: **Ter Meer Steinmeister & Partner Patentanwälte mbB**
**Nymphenburger Straße 4**
**80335 München (DE)**

(54) **SILICONE COMPOSITION, HEAT DISSIPATION MEMBER, AND ELECTRONIC DEVICE**

(57) A silicone composition comprising: (a) a specific organopolysiloxane; (b) an organohydrogenpolysiloxane having Si-H at both two molecular chain ends and molecular-chain side chains, the number of Si-H in the molecular-chain side chains being 4 to 15; (c) a thermally conductive filler; and (d) a curing catalyst; the silicone composition comprising: a first agent comprising the components (a), (c) and (d) and not comprising the component (b) in combination with a second agent comprising the components (a), (b) and (c) and not comprising the component (d); a difference in viscosity at 23°C between the components (a) and (b) in the second agent is 400 mPa·s or less; and a ratio (H/Vi) of the number of Si-H to the number of alkenyl groups is in the range of 0.5 or more and 1.5 or less.

EP 4 541 858 A1

## Description

### Technical Field

The present invention relates to a silicone composition, a heat-dissipating member formed from the composition, and an electronic component comprising the heat-dissipating member.

### Background Art

In electronic devices, integrated electronic components may generate heat, which causes failures. Therefore, heat-dissipating members have been conventionally widely used to dissipate the heat generated from the electronic components to the outside of the device. The heat-dissipating member is disposed between a heat-generating element such as an electronic component and a heat-dissipating element such as a housing or a heat sink. The heat-dissipating member is often formed by curing a silicone composition containing a silicone resin and a thermally conductive filler, as disclosed, for example, in PTLs 1 to 6.

In recent years, with the miniaturization and higher performance of electric devices, the heat-dissipating members are required to be increased in thermal conductivity in order to more efficiently dissipate the heat generated by driving the electrical devices. In order to increase the thermal conductivity, the filling ratio of a thermally conductive filler is considered to be increased.

### Citation List

### Patent Literature

PTL1: International Publication No. WO 2019/181713
PTL2: Japanese Patent Laid-Open No. 2009-179714
PTL3: Japanese Patent Laid-Open No. 2016-53140
PTL4: Japanese Patent Laid-Open No. 2016-79204
PTL5: International Publication No. WO 2019/021824
PTL6: International Publication No. WO 2019/021826

### Summary of Invention

### Technical Problem

However, if the filling rate of the thermally conductive filler is increased, the viscosity of a compound before curing may increase, resulting in a decrease in flowability, and the hardness of the compound after curing may increase, increasing the stress on the surrounding electronic components, which results in damage to the electronic components. In addition, there is the problem that the reliability when used for a long period of time, so-called long-term reliability, is insufficient. Specifically, when used for a long period of time under a high-temperature environment, the hardness increases, which may lead to the problems that the heat-dissipating member is detached from the heat-generating element or the like due to vibration or impact, resulting in a deterioration in thermal resistance value.

The silicone compositions have also sometimes been used as two-part curing type silicone compositions. In the case of a two-part curing type silicone composition, each component is divided into a first agent and a second agent in advance, and the first agent and the second agent are mixed before used and cured to obtain a cured product. In the two-part curing type silicone composition, it is common for the first agent to contain an alkenyl group-containing organopolysiloxane and for the second agent to contain an organohydrogenpolysiloxane, but the second agent may also contain the alkenyl group-containing organopolysiloxane in order to equalize the mass ratio between the first agent and the second agent. However, if the second agent contains the alkenyl group-containing organopolysiloxane in addition to the organohydrogenpolysiloxane, oil bleeding may occur during storage, leading to insufficient storage stability.

On the other hand, various types of research have been made to resolve the problems associated with highly filling the thermally conductive fillers in conventional silicone compositions. For example, in PTL 1, an attempt is made to improve the flowability by further incorporating a slightly volatile isoparaffin compound having a boiling point of 160 to 360°C into a silicone composition containing an organopolysiloxane having an aliphatic unsaturated hydrocarbon group, an organohydrogenpolysiloxane, a thermally conductive filler, and the like. However, it has been difficult for conventional silicone compositions to be improved in all of flexibility, long-term reliability and oil bleeding properties while increasing the

thermal conductivity.

Therefore, it is an object of the present invention to provide a two-part curing type silicone composition that can be improved in all of flexibility, long-term reliability and oil bleeding properties while increasing the thermal conductivity of a heat-dissipating member produced from the silicone composition.

Solution to Problem

After diligent research, the present inventors have found that the above problems can be resolved by keeping the ratio between Si-H and alkenyl groups in the composition constant, using a specific organohydrogenpolysiloxane, and keeping the difference in viscosity between specific components at a certain value or less, and have completed the present invention as described below. That is, the present invention provides the [1] to [26] as follows:

[1] A silicone composition comprising:

(a) an organopolysiloxane having at least two alkenyl groups in one molecule;
(b) an organohydrogenpolysiloxane having hydrogen atoms directly bonded to silicon atoms at both two molecular chain ends and molecular-chain side chains, the number of the hydrogen atoms in the molecular-chain side chains being 4 to 15;
(c) a thermally conductive filler; and
(d) a curing catalyst;

the silicone composition comprising: a combination of a first agent comprising the components (a), (c) and (d) and not comprising the component (b); and a second agent comprising the components (a), (b) and (c) and not comprising the component (d);
a difference in viscosity at 23°C between the components (a) and (b) in the second agent is 400 mPa·s or less; and a ratio of the number of hydrogen atoms directly bonded to silicon atoms to the number of alkenyl groups (H/Vi) is in the range of 0.5 or more and 1.5 or less.

[2] The silicone composition according to the above [1], comprising an organosilicon compound having a hydrolyzable silyl group at the molecular chain end.
[3] The silicone composition according to the above [1] or [2], comprising at least one selected from the group consisting of (e) an organopolysiloxane having no addition reactive group and (f) a silane coupling agent.
[4] The silicone composition according to the above [3], wherein each of the first agent and the second agent comprises at least one selected from the group consisting of the components (e) and (f).
[5] The silicone composition according to the above [3] or [4], comprising, as the component (e), (e-1) an organopolysiloxane having a hydrolyzable silyl group at the molecular chain end.
[6] The silicone composition according to any of the above [3] to [5], comprising, as the component (e), at least one compound selected from the group consisting of a compound represented by the following formula (1) and a compound represented by the following formula (2):

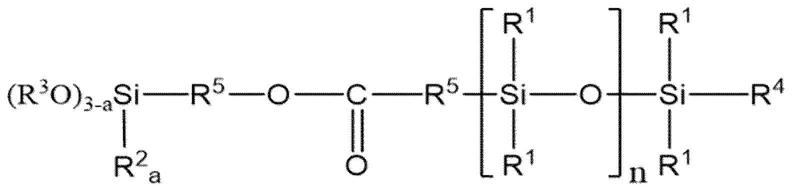
(1)

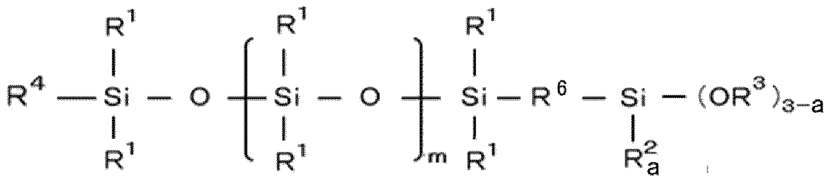
(2)

wherein:

in each of the formulas (1) and (2), each $R^1$ is independently any one of an alkyl group having 1 to 20 carbon atoms, a halogenated alkyl group having 1 to 20 carbon atoms, an aryl group having 6 to 20 carbon atoms and an

aralkyl group having 7 to 20 carbon atoms, and the multiple $R^1$s in each formula may be each the same or different; each $R^2$ is independently an alkyl group having 1 to 4 carbon atoms, and when multiple $R^2$s are present in each formula, the multiple $R^2$s may be each the same or different; each $R^3$ is independently any one of an alkyl group having 1 to 4 carbon atoms, an alkoxyalkyl group having 2 to 4 carbon atoms and an acyl group having 2 to 4 carbon atoms, and when multiple $R^3$s are present in each formula, the multiple $R^3$s may be each the same or different; and each $R^4$ is independently an alkyl group having 1 to 8 carbon atoms;

in the formula (1), each $R^5$ is independently a divalent hydrocarbon group having 2 to 20 carbon atoms, and the multiple $R^5$s may be each the same or different;

in the formula (2), $R^6$ is an oxygen atom or a divalent hydrocarbon group having 2 to 20 carbon atoms;

in each of the formulas (1) and (2), a is an integer from 0 to 2;

in the formula (1), n is an integer from 4 to 150; and

in the formula (2), m is an integer from 15 to 315.

[7] The silicone composition according to any of the above [1] to [6], wherein a viscosity at 23°C of the component (a) is 20 m·Pa or more and 100,000 m·Pa or less.

[8] The silicone composition according to any of the above [1] to [7], wherein a content of the (c) thermally conductive filler is 1,000 parts by mass or more and 4,000 parts by mass or less relative to 100 parts by mass of the organopolysiloxane in the silicone composition.

[9] The silicone composition according to any of the above [1] to [8], wherein a content of the (d) curing catalyst is 0.1 ppm by mass or more and 500 ppm by mass or less.

[10] The silicone composition according to any of the above [1] to [9], wherein the second agent comprises (g) a curing inhibitor.

[11] The silicone composition according to any of the above [1] to [10], wherein the organohydrogenpolysiloxane in the silicone composition consists of an organohydrogenpolysiloxane having hydrogen atoms directly bonded to the silicon atoms at both the two molecular chain ends and the molecular-chain side chains.

[12] The silicone composition according to any of the above [1] to [11], wherein the (c) thermally conductive filler is at least one selected from the group consisting of an oxide, a nitride, a carbide, a carbon-based material and a metal hydroxide.

[13] The silicone composition according to any of the above [1] to [12], wherein the (c) thermally conductive filler is at least one selected from the group consisting of alumina, diamond and aluminum nitride.

[14] The silicone composition according to any of the above [1] to [13], wherein primary particles of the (c) thermally conductive filler have an average particle diameter of 0.1 μm or more.

[15] The silicone composition according to any of the above [1] to [14], wherein the (c) thermally conductive filler comprises two or more types of particles different in average particle diameters of the primary particles.

[16] The silicone composition according to any of the above [1] to [15], wherein a cured product obtained by curing the silicone composition has a type E hardness of less than 70.

[17] The silicone composition according to any of the above [1] to [16], wherein a viscosity at 23°C of the component (a) in the second agent is 20 m·Pa or more and 100,000 m·Pa or less.

[18] The silicone composition according to any of the above [1] to [17], wherein a viscosity at 23°C of the component (b) in the second agent is 20 m·Pa or more and 100,000 m·Pa or less.

[19] The silicone composition according to any of the above [1] to [18], wherein a mass ratio ((a2+b2)/a1) of a total content of the components (a) and (b) in the second agent to a content of the component (a) in the first agent is 0.8 or more and 1.2 or less.

[20] The silicone composition according to any of the above [1] to [21], wherein a mass ratio (c2/c1) of a content of the component (c) in the second agent to a content of the component (c) in the first agent is 0.8 or more and 1.2 or less.

[21] The silicone composition according to any of the above [1] to [20], wherein the content of the component (a) is 30% by mass or more and 92% by mass or less and a content of the component (b) is 3% by mass or more and 40% by mass or less, relative to a total amount of organopolysiloxane, in the silicone composition.

[22] The silicone composition according to any of the above [1] to [21], wherein the component (a) comprises alkenyl groups at two molecular chain ends.

[23] The silicone composition according to any of the above [1] to [22], wherein the (d) curing catalyst is a platinum-based catalyst.

[24] The silicone composition according to any of the above [1] to [23], wherein primary particles of the (c) thermally conductive filler have an average particle diameter of 200 μm or less.

[25] A heat-dissipating member formed from the silicone composition according to any of the above [1] to [24].

[26] An electronic device comprising an electronic component and the heat-dissipating member according to the above [25] disposed on the electronic component.

## Advantageous Effect of Invention

By using the two-part curing type silicone composition of the present invention, a heat-dissipating member that is improved in flexibility, long-term reliability and oil bleeding properties can be obtained even when the thermal conductivity is increased.

## Description of Embodiments

### [Silicone composition]

The silicone composition of the present invention will be described in detail below.
The silicone composition of the present invention comprises the following components (a), (b), (c) and (d). The silicone composition of the present invention preferably comprises at least one of the following components (e) and (f). Hereinafter, each component will be described in detail.

### <Component (a)>

The component (a) is an organopolysiloxane having at least two alkenyl groups in one molecule. By including the component (a), the silicone composition can be cured by subjecting it to addition reaction with an organohydrogenpolysiloxane (the component (b)) described below.
The organopolysiloxane to be used as the component (a) may be linear or branched or may be a mixture of linear and branched, but it is preferably linear.
The alkenyl group in the component (a) may be included at either a molecular chain end or molecular-chain side chains of the polysiloxane structure of the component (a), or may be included at both molecular-chain side chains and a molecular chain end, but it is preferably included at least at a molecular chain end, more preferably at the two molecular chain ends, and even more preferably only at the two molecular chain ends.
Examples of the alkenyl group include, but not particularly limited to, an alkenyl group having 2 to 8 carbon atoms, such as a vinyl group, an allyl group, a butenyl group, a pentenyl group, a hexenyl group, a heptenyl group or an octenyl group. Of these, a vinyl group is preferred, from the viewpoint of ease of synthesis, reactivity, and the like. In addition, it is preferred that the alkenyl group is an alkenyl group directly bonded to a silicon atom.
The number of alkenyl groups in one molecule of the component (a) is not particularly limited as long as it is 2 or more, but it is, for example, 2 to 8, preferably 2 to 4, and more preferably 2.
Examples of the other group bonded to a silicon atom in addition to the alkenyl group in the organopolysiloxane of the component (a) include a hydrocarbon group optionally having a substituent. Examples of the hydrocarbon group optionally having a substituent include a hydrocarbon group having about 1 to 20 carbon atoms. Specific examples thereof include an alkyl group having 1 to 20 carbon atoms, a halogenated alkyl group having 1 to 20 carbon atoms, an aryl group having 6 to 20 carbon atoms and an aralkyl group having 7 to 20 carbon atoms.
The alkyl group may be linear or branched, or may have a cyclic structure. More specific examples of the hydrocarbon group include a linear alkyl group such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group or an eicosyl group; a branched alkyl group such as an isopropyl group, a tertiary butyl group, an isobutyl group, a 2-methylundecyl group or a 1-hexylheptyl group; and a cyclic alkyl group such as a cyclopentyl group, a cyclohexyl group or a cyclododecyl group.
Examples of the halogenated alkyl group include a chloromethyl group, a 3,3,3-trifluoropropyl group and a 3-chloropropyl group. Examples of the aryl group include a phenyl group, a tolyl group and a xylyl group. Example of the aralkyl group include a benzyl group, a phenethyl group and a 2-(2,4,6-trimethylphenyl)propyl group.
Of these, an alkyl group is preferred, and a methyl group is preferred from the viewpoint of ease of synthesis. **In** addition, preferably 80 mol% or more, more preferably 90 mol% or more, and even more preferably 100% of the other group bonded to a silicon atom is a methyl group. It is preferred that the component (a) comprises no hydrogen atom as the other group bonded to a silicon atom, that is, it comprises no hydrosilyl group.
Specific examples of the component (a) include a compound represented by the following formula (A).

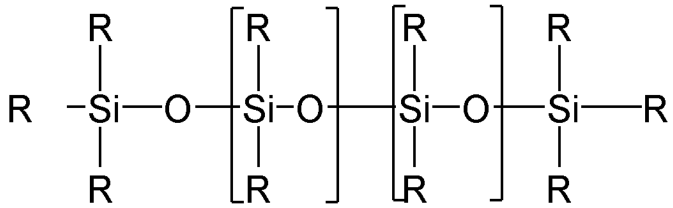

(A)

In the formula (A), each $R^{11}$ is independently a hydrocarbon group optionally having a substituent other than an alkenyl group. Each $R^{12}$ is independently an alkenyl group. Details of the hydrocarbon group optionally having a substituent and the alkenyl group are as described above. $R^{11}$ is preferably an alkyl group and more preferably a methyl group. Preferably 80 mol% or more, more preferably 90 mol% or more and even more preferably 100% of $R^{11}$ is a methyl group. $R^{12}$ is preferably a vinyl group.

In the formula (A), the character of p is the number of repeating units and is, for example, an integer of 0 to 8, preferably 0 to 2 and more preferably 0. The character of q is the number of repeating units and is an integer of 1 or more, but it is preferably such a number of repeating units that the viscosity at 23°C is within the range described below, and it is, for example, about 20 to 1,500.

In the formula (A), the structural unit represented by $-SiR^{11}R^{12}O-$ and the structural unit represented by $-SiR^{11}R^{11}O-$ may be polymerized randomly or in blocks.

The organopolysiloxane of the component (a) may be used alone or in combination of two or more thereof.

The viscosity at 23°C of the component (a) is not particularly limited, but is preferably 20 mPa·s or more and 100,000 mPa·s or less. The viscosity of the component (a) of the above lower limit value or more prevents the crosslink density from being too high in the cured product, making it easier to maintain the flexibility after curing. The viscosity of the component (a) of the above upper limit or less can prevent the silicone composition from being highly viscous. The viscosity of the component (a) within the above range makes it easier to keep the difference in viscosity between the component (a) and the component (b) described below at a certain level or less, and also makes the molecular weight of the component (a) appropriate, making it easier to make the reactivity proper.

The viscosity at 23°C of the component (a) is more preferably 40 mPa·s or more and 10,000 mPa·s or less, even more preferably 60 mPa·s or more and 1,000 mPa·s or less, and still even more preferably 80 mPa·s or more and 500 mPa·s or less.

The viscosity at 23°C of the component (a) can be measured with a Brookfield B-type viscometer. In the Brookfield B-type viscometer, it is preferred that the spindle is properly selected so that the torque is 10 to 80%. The same applies to the viscosity of the component (b) described below, and the like.

The content of the component (a) in the silicone composition may be appropriately selected so that the ratio (H/Vi) described below, and the like can be adjusted within the desired range, and it is not particularly limited, but it is, for example, 30% by mass or more and 92% by mass or less, preferably 40% by mass or more and 87% by mass or less, and more preferably 50% by mass or more and 84% by mass or less, relative to the total amount of organopolysiloxane in the silicone composition.

<Component (b)>

The component (b) is an organohydrogenpolysiloxane having hydrogen atoms directly bonded to silicon atoms (hereinafter sometimes referred to as "Si-H") at both the two molecular chain ends and the molecular-chain side chains, and the number of Si-H in the molecular-chain side chains is 4 to 15.

By including an organohydrogenpolysiloxane having Si-H at both the two molecular chain ends and molecular-chain side chains in the silicone composition of the present invention, the silicone composition can be cured while subjecting it to chain extension and crosslinking. The number of Si-H in side chains within a certain range allows a proper chain extension and curing while ensuring a certain crosslink density. Therefore, even when the (c) thermally conductive filler is highly filled, the flexibility after curing can be ensured, while even when the product is heated at a high temperature for a long period of time after curing, an increase in hardness can be suppressed, ensuring long-term reliability. That is, by suppressing an increase in hardness even when heated for a long period of time, the cured product of the silicone composition can be suppressed from detaching from a heat-generating element and the like even when exposed to vibration or impact, thereby maintaining a good thermal resistance for a long period of time.

The organohydrogenpolysiloxane having Si-H at the two molecular chain ends easily causes oil bleeding when mixed with an alkenyl-containing organopolysiloxane, but the compatibility thereof with the component (a) is improved by keeping the number of Si-H in the molecular-chain side chains within a certain range. This, in combination with adjusting the viscosity difference as described below, makes oil bleeding less likely to be caused.

The organohydrogenpolysiloxane to be used as the component (b) may be linear or branched or may be a

mixture of linear and branched, but it is preferably linear. It is preferred that the component (b) has one Si-H at each of two ends of the linear molecular chain, and 4 to 15 Si-H groups at the side chains.

In the component (b), the number of Si-H present in the side chains in one molecule is 4 to 15 as described above, but is preferably 4 to 14 and more preferably 4 to 12. The appropriate number of Si-H in the side chains in the component (b) ensures flexibility while making it easier to provide a good long-term reliability.

In the component (b), examples of the other group bonded to a silicon atom in addition to Si-H include a hydrocarbon group optionally having a substituent. Examples of the hydrocarbon group optionally having a substituent include a hydrocarbon group having about 1 to 20 carbon atoms. Specific examples thereof include an alkyl group having 1 to 20 carbon atoms, a halogenated alkyl group having 1 to 20 carbon atoms, an aryl group having 6 to 20 carbon atoms and an aralkyl group having 7 to 20 carbon atoms. Details of the alkyl group, the halogenated alkyl group, the aryl group and the aralkyl group are as described above for the component (a).

The other group is preferably an alkyl group, and preferably a methyl group from the viewpoint of ease of synthesis and the like. In addition, preferably 80 mol% or more, more preferably 90 mol% or more, and even more preferably 100% of the other group bonded to a silicon atom is a methyl group.

It is preferred that the component (b) comprises no alkenyl group as the other group bonded to a silicon atom, that is, the component (b) comprises no alkenyl group.

Specific examples of the component (b) include a compound represented by the following formula (B).

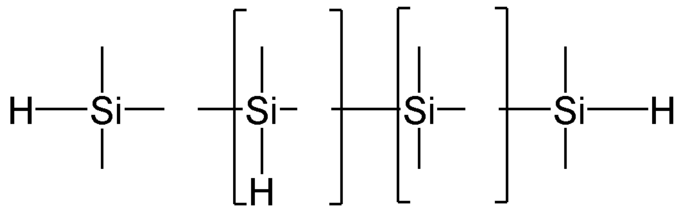

(A)

In the formula (B), each $R^{13}$ is independently a hydrocarbon group optionally having a substituent other than an alkenyl group. Details of the hydrocarbon group optionally having a substituent are as described above. $R^{13}$ is preferably an alkyl group, and more preferably a methyl group. In addition, preferably 80% or more, more preferably 90% or more, and even more preferably 100% of $R^{13}$ in the formula (B) is a methyl group.

In the formula (B), the character of r is the number of repeating units and is an integer selected from 4 to 15, preferably 4 to 14 and more preferably 4 to 12. The character of s is the number of repeating units and is an integer of 1 or more, but it is preferably such a number of repeating units that the viscosity at 23°C is within the range described below, and it is, for example, about 20 to 1,500.

In the formula (B), the structural unit represented by $-SiHR^{13}O-$ and the structural unit represented by $-SiR^{13}R^{13}O-$ may be polymerized randomly or in blocks.

The organohydrogenpolysiloxane of the component (b) may be used alone or in combination of two or more thereof.

The viscosity at 23°C of the component (b) is not particularly limited, but is preferably 20 mPa·s or more and 100,000 mPa·s or less. The viscosity within the above range of the component (b) prevents the crosslink density from being too high, so that the silicone composition can be maintained flexible after curing while preventing it from being highly viscous. In addition, the viscosity within the above range of the component (b) makes it easier to make the difference in viscosity between the component (b) and the component (a) at a certain level or less, and also makes the molecular weight of the component (b) appropriate, making it easier to make the reactivity proper. The viscosity at 23°C of the component (b) is more preferably 20 mPa·s or more and 10,000 mPa·s or less, even more preferably 30 mPa·s or more and 1,000 mPa·s or less, and still even more preferably 40 mPa·s or more and 500 mPa·s or less. The viscosity at 23°C of the component (b) is typically less than the viscosity at 23°C of the component (a), but it may be no less than the viscosity at 23°C of the component (a).

The content of the component (b) in the silicone composition may be appropriately selected so that the ratio (H/Vi) described below, and the like can be adjusted within the desired range, and it is not particularly limited, but it is, for example, 3% by mass or more and 40% by mass or less, preferably 4% by mass or more and 35% by mass or less, and more preferably 7% by mass or more and 30% by mass or less, relative to the total amount of organopolysiloxane in the silicone composition.

<Component (c)>

The component (c) is a thermally conductive filler. By including a thermally conductive filler in the silicone composition, the silicone composition and the cured product (heat-dissipating member) obtained by curing the silicone

composition are improved in thermal conductivity.

The (c) thermally conductive filler is not particularly limited, but it is preferably at least one selected from the group consisting of an oxide, a nitride, a carbide, a carbon-based material and a metal hydroxide.

Examples of the oxide include a metal oxide such as iron oxide, zinc oxide, alumina, magnesium oxide, titanium oxide, cerium oxide or zirconium oxide, and an oxide other than a metal oxide such as silicon oxide (silica).

Examples of the nitride include a metal nitride such as aluminum nitride, gallium nitride, chromium nitride, tungsten nitride, magnesium nitride, molybdenum nitride or lithium nitride, and a nitride other than a metal nitride such as silicon nitride or boron nitride.

Examples of the carbide include a metal carbide such as aluminum carbide, titanium carbide or tungsten carbide, and a carbide other than a metal carbide such as silicon carbide or boron carbide.

Examples of the carbon-based material include a diamond particle, carbon black, graphite, graphene, fullerene, a carbon nanotube and a carbon nanofiber.

Examples of the metal hydroxide include aluminum hydroxide, calcium hydroxide and magnesium hydroxide.

These thermally conductive fillers may be used alone or in combination of two or more thereof.

Of the above, the thermally conductive filler is preferably at least one selected from the group consisting of alumina, diamond and aluminum nitride, from the viewpoint of easily improving thermal conductivity.

The average particle diameter of primary particles of the (c) thermally conductive filler is not particularly limited, but it is preferably 0.1 μm or more. The average particle diameter of 0.1 μm or more easily increase the thermal conductivity of the silicone composition and easily decrease the viscosity of the silicone composition. The average particle diameter of primary particles of the (c) thermally conductive filler is more preferably 0.2 μm or more and even preferably 0.5 μm or more.

The average particle diameter of primary particles of the (c) thermally conductive filler is preferably 200 μm or less. The average particle diameter of 200 μm or less allows the (c) thermally conductive filler to be properly dispersed in the silicone composition, so that the silicone composition can comprise the (c) thermally conductive filler at a high filling rate. The average particle diameter of primary particles of the (c) thermally conductive filler is more preferably 150 μm or less, and even more preferably 100 μm or less.

The average particle diameter of primary particles can be measured, for example, with a "laser diffraction particle size analyzer" manufactured by Horiba, Ltd., and the particle diameter at 50% cumulative volume (d50) may be taken as an average particle diameter of the primary particles.

The (c) thermally conductive filler preferably comprises two or more types of particles different in average particle diameters of the primary particles. When two or more types of particles different in average particle diameters of primary particles are used, the particles with the smaller average particle diameter enter between the particles with the larger average particle diameter, so that the thermally conductive filler is properly dispersed in an organopolysiloxane while the filling rate of the thermally conductive filler is easily increased. The silicone composition can be determined to have two or more types of particles different in average particle diameters of the primary particles when two or more peaks appear in the particle size distribution of the thermally conductive filler.

When the (c) thermally conductive filler comprises two or more types of particles different in average particle diameters of the primary particles, the specific particle diameter thereof can be selected depending on the type of thermally conductive filler. For example, a thermally conductive filler having an average particle diameter of primary particles of 10 μm or more and 200 μm or less and a thermally conductive filler having an average particle diameter of primary particles of 0.1 μm or more and less than 10 μm may be used in combination.

For example, a thermally conductive filler having an average particle diameter of primary particles of 1 μm or more and 100 μm or less (large particle diameter-thermally conductive filler) and a thermally conductive filler having an average particle diameter of primary particles of 0.1 μm or more and less than 1 μm (small particle diameter-thermally conductive filler) may be used in combination. In this case, the average particle diameter of the primary particles of the large particle diameter-thermally conductive filler is preferably 2 μm or more and 80 μm or less, and more preferably 2 μm or more and 50 μm or less. The average particle diameter of the primary particles of the small particle diameter-thermally conductive filler is preferably 0.1 μm or more and 0.8 μm or less.

The content of the (c) thermally conductive filler in the silicone composition is, for example, 500 parts by mass or more, preferably 800 parts by mass or more, and more preferably 1,000 parts by mass or more, relative to 100 parts by mass of the organopolysiloxane in the silicone composition. When the content of the (c) thermally conductive filler is 500 parts by mass or more, the thermal conductivity can be improved, and when the content is 1,000 parts by mass or more, the thermal conductivity can be sufficiently increased.

The content of the (c) thermally conductive filler is, for example, 4,000 parts by mass or less, preferably 3,000 parts by mass or less, and more preferably 2,500 parts by mass or less, relative to 100 parts by mass of the organopolysiloxane. When the content of the (c) thermally conductive filler is such an upper limit or less, the thermally conductive filler can be properly dispersed in the silicone composition. In addition, the viscosity of the silicone composition can be prevented from being higher than necessary.

The (c) thermally conductive filler can be a thermally conductive filler surface-treated with an organosilicon compound having a hydrolyzable silyl group at a molecular chain end, such as the component (e-1) or (f) described later. In particular, the (c) thermally conductive filler is preferably surface-treated with the component (e-1).

The surface-treated thermally conductive filler can be obtained by mixing the (c) thermally conductive filler with an organosilicon compound having a hydrolyzable silyl group at the molecular chain end, such as the component (e-1) or (f) described below. In addition, it is preferable to use a wet treatment process, a dry treatment process, or the like from the viewpoint of easily promoting the surface treatment during mixing.

In the wet treatment process, for example, the (c) thermally conductive filler is added to and mixed with a solution in which the component (e-1) or (f) described below is dispersed or dissolved, and then heat-treated to bond or adhere the component (e-1) or (f) to the surface of the thermally conductive filler.

The dry treatment process is a process of surface treatment without using a solution, and specifically, a method in which the (c) thermally conductive filler is mixed with the component (e-1) or (f), stirred with a mixer or the like, and then heat-treated to bond or adhere the component (e-1) or (f) to the surface of the thermally conductive filler. The surface treatment carried out by mixing the (c) thermally conductive filler with the component (e-1) or (f) can also be carried out in the presence of the component (a) or (b) described above or the component (e-2) described below.

<Component (d)>

The component (d) is a curing catalyst. By including a curing catalyst in the silicone composition, the curing catalyst can promote the addition reaction between an organopolysiloxane having an alkenyl group (such as a component (a)) and an organohydrogenpolysiloxane (such as a component (b)), thereby properly curing the silicone composition.

Examples of the curing catalyst include a platinum-based catalyst, a palladium-based catalyst and a rhodium-based catalyst. Of these, a platinum-based catalyst is preferred. Examples of the platinum-based catalyst include, but are not limited to, chloroplatinic acid, and a complex compound of chloroplatinic acid with an olefin, a vinylsiloxane or an acetylenic compound.

The content of the curing catalyst in the silicone composition is not particularly limited as long as it is an amount that can promote the addition reaction, but it is preferably 0.1 ppm by mass or more and 500 ppm by mass or less, more preferably 0.5 ppm by mass or more and 200 ppm by mass or less, and even more preferably 1 ppm by mass or more and 100 ppm by mass or less, based on the total amount of the silicone composition.

<<Components (e) and (f)>>

The silicone composition of the present invention preferably comprises an organosilicon compound having no addition reactive group. Specifically, it preferably comprises at least one of an organopolysiloxane having no addition reactive group (a component (e)) and a silane coupling agent having no addition reactive group (a component (f)), and it more preferably comprises the component (e).

The organosilicon compound having no addition reactive group, more specifically the component (e) and (f) are preferably an organosilicon compound having a hydrolyzable silyl group, particularly having a hydrolyzable silyl group at a molecular chain end. More specifically, it is preferably an organopolysiloxane having a hydrolyzable silyl group at a molecular chain end (component (e-1)), or a silane coupling agent having a hydrolyzable silyl group at the molecular chain end (component (f)), as described below. By using the organosilicon compound with a hydrolyzable silyl group at a molecular chain end, the filler is made easily dispersed, so that the (c) thermally conductive filler can be highly filled and the thermal conductivity becomes high.

<Component (e)>

The component (e) is an organopolysiloxane having no addition reactive group. When the silicone composition of the present invention comprises the component (e), the silicone composition of the present invention does not incorporate a certain amount or more of the component into the crosslinked structure in the cured product, making it easier to improve flexibility. **In** addition, the viscosity of the silicone composition is made easily decreased, and the handleability thereof is made thereby easily improved. The addition reactive group means a functional group that reacts by addition reaction, and representative examples thereof include an alkenyl group, a methacryloyl group, an acryloyl group, and a hydrosilyl group.

Examples of the component (e) include (e-1) an organopolysiloxane having a hydrolyzable silyl group at the molecular chain end and (e-2) silicone oil. The component (e) may comprise either the component (e-1) or the component (e-2), but preferably comprises at least the component (e-1). When the component (e) comprises the component (e-1), the viscosity of the silicone composition is made further easily decreased. In addition, the filler is made easily dispersed, and as a result, the (c) thermally conductive filler can be highly filled, and the thermal conductivity increases.

As described above, the component (e-1) may surface-treat the (c) thermally conductive filler, and by surface-treating the (c) thermally conductive filler with the component (e-1), the dispersibility of the filler can be further improved.

When the silicone composition comprises the component (e-1), it may further comprise the component (e-2).

The component (e-1) may be linear or branched or may be a mixture of linear and branched, but it is preferably linear. The component (e-1) is preferably an organopolysiloxane having at least one hydrolyzable silyl group at a molecular chain end, more preferably an organopolysiloxane having at least one hydrolyzable silyl group only at one molecular chain end, and even more preferably an organopolysiloxane having three hydrolyzable silyl groups at one molecular chain end. Here, the hydrolyzable silyl group is preferably an alkoxysilyl group and more preferably a methoxysilyl group.

It is presumed that the component (e-1) easily reacts or interacts with functional groups present on the surface of the thermally conductive filler, and the like because of having a hydrolyzable silyl group at a molecular chain end, and also in combination with the presence of a polysiloxane structure, the dispersibility of the filler is improved and the viscosity of the silicone composition is made easily decreased. In addition, the dispersibility of the filler is improved, so that the (c) thermally conductive filler can be highly filled and the thermal conductivity is thereby easily increased.

Examples of the component (e-1) include a compound represented by the following formula (1) and a compound represented by the following formula (2). Of these, the compound represented by the following formula (1) is preferred. The compound represented by formula (1) can suppress changes in physical properties of the silicone composition at high temperatures and can also improve the dispersibility. This is presumed to be attributable to the ester structure of the compound represented by formula (1).

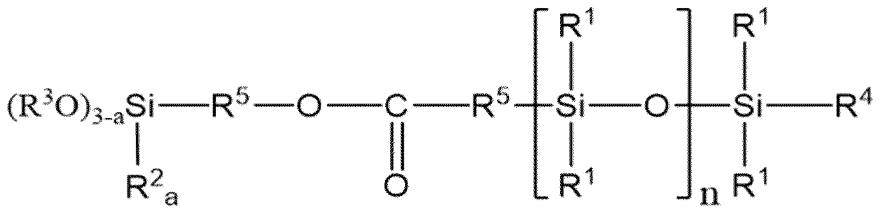

(1)

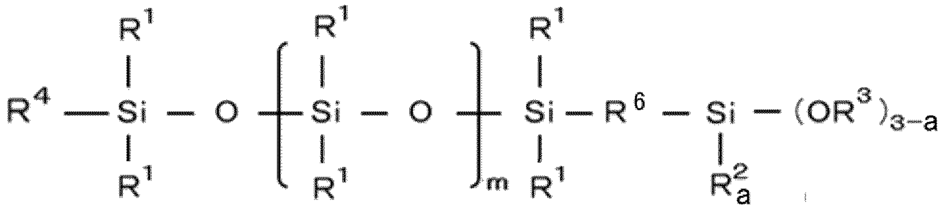

(2)

In each of the formulas (1) and (2), each $R^1$ is independently any one of an alkyl group having 1 to 20 carbon atoms, a halogenated alkyl group having 1 to 20 carbon atoms, an aryl group having 6 to 20 carbon atoms and an aralkyl group having 7 to 20 carbon atoms, and the multiple $R^1$s in each formula may be each the same or different. Each $R^2$ is independently an alkyl group having 1 to 4 carbon atoms, and when multiple $R^2$s are present in each formula, the multiple $R^2$s may be each the same or different. Each $R^3$ is independently any one of an alkyl group having 1 to 4 carbon atoms, an alkoxyalkyl group having 2 to 4 carbon atoms and an acyl group having 2 to 4 carbon atoms, and when multiple $R^3$s are present in each formula, the multiple $R^3$s may be each the same or different. Each $R^4$ is independently an alkyl group having 1 to 8 carbon atoms. In the formula (1), each $R^5$ is independently a divalent hydrocarbon group having 2 to 20 carbon atoms, and the multiple $R^5$s may be each the same or different. In the formula (2), $R^6$ is an oxygen atom or a divalent hydrocarbon group having 2 to 20 carbon atoms. In each of the formulas (1) and (2), the character of a is an integer from 0 to 2. In the formula (1), the character of n is an integer from 4 to 150, and in the formula (2), the character of m is an integer from 15 to 315.

In each of the above formulas (1) and (2), examples of $R^1$ include an alkyl group having 1 to 20 carbon atoms, a halogenated alkyl group having 1 to 20 carbon atoms, an aryl group having 6 to 20 carbon atoms and an aralkyl group having 7 to 20 carbon atoms. The multiple $R^1$'s may be each the same or different.

The alkyl group may be linear or branched, or may have a cyclic structure. More specific examples of the alkyl group include a linear alkyl group such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group or an eicosyl group; a branched alkyl group such as an isopropyl group, a tertiary butyl group, an isobutyl group, a 2-methylundecyl group or a 1-hexylheptyl group; and a cyclic alkyl group such as a cyclopentyl group, a cyclohexyl group or a cyclododecyl group.

Examples of the halogenated alkyl group include a chloromethyl group, a 3,3,3-trifluoropropyl group and a 3-chloropropyl group. Examples of the aryl group include a phenyl group, a tolyl group and a xylyl group. Example of the

aralkyl group include a benzyl group, a phenethyl group and a 2-(2,4,6-trimethylphenyl)propyl group.

Of these, $R^1$ is preferably an alkyl group having 1 to 20 carbon atoms, more preferably an alkyl group having 1 to 4 carbon atoms, and even more preferably a methyl group.

In each of the above formulas (1) and (2), $R^2$ is an alkyl group having 1 to 4 carbon atoms, and when multiple $R^2$s are present (that is, when the character of a is 2), the multiple $R^2$s may be each the same or different. The alkyl group may be linear or branched. In particular, $R^2$ is preferably an alkyl group having 1 to 2 carbon atoms, and more preferably a methyl group. The character of a is an integer of 0 to 2, and the character of a is preferably 0 or 1 and more preferably 0.

In each of the above formulas (1) and (2), $R^3$ is an alkyl group having 1 to 4 carbon atoms, an alkoxyalkyl group having 2 to 4 carbon atoms or an acyl group having 2 to 4 carbon atoms, and when multiple $R^3$s are present (that is, when the character of a is 0 or 1), the multiple $R^3$s may be each the same or different. The alkyl group, alkoxyalkyl group and acyl group in $R^3$ may be each linear or branched. Of these, $R^3$ is preferably an alkyl group having 1 to 4 carbon atoms, and more preferably a methyl group.

In each of the above formulas (1) and (2), $R^4$ is an alkyl group having 1 to 8 carbon atoms, preferably an alkyl group having 2 to 6 carbon atoms, and more preferably a butyl group.

In the formula (1), $R^5$ is a divalent hydrocarbon group having 1 to 20 carbon atoms, and the multiple $R^5$s may be each the same or different. The divalent hydrocarbon group is preferably an alkylene group, and the alkylene group may be linear or branched. $R^5$ is preferably an alkylene group having 2 to 10 carbon atoms, more preferably an alkylene group having 2 to 8 carbon atoms, even more preferably an alkylene group having 2 to 4 carbon atoms, and still more preferably an alkylene group represented by $-CH_2-CH_2-CH_2-$ or $-CH(CH_3)-CH_2-$.

In the formula (2), $R^6$ is an oxygen atom or a divalent hydrocarbon group having 1 to 20 carbon atoms, and preferably a divalent hydrocarbon group. The divalent hydrocarbon group is preferably an alkylene group, and the alkylene group may be linear or branched. $R^6$ is preferably an alkylene group having 2 to 10 carbon atoms, more preferably an alkylene group having 2 to 8 carbon atoms, and even more preferably an alkylene group having 2 to 4 carbon atoms. Examples thereof include a methylene group, an ethylene group, a propylene group, a butylene group and a methylethylene group. Of these, an ethylene group is preferred.

In the formula (1), the character of n represents the number of repeating units, and it is an integer of 4 to 150, preferably an integer of 5 to 120, and more preferably an integer of 5 to 50.

In the formula (2), the character of m represents the number of repeating units, and it is an integer of 15 to 315, preferably an integer of 18 to 280, and more preferably an integer of 20 to 220.

From the viewpoint of increasing the dispersibility of the thermally conductive filler and obtaining the silicone composition wherein its physical properties less change at high temperature, among the compounds represented by the formulas (1) and (2), the compound represented by the following formula (1-1) or (2-1) is preferred, and the compound represented by the following formula (1-1) is particularly preferred.

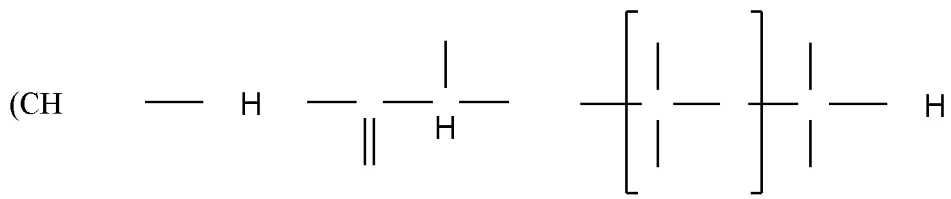

Here, the character of n is as described above.

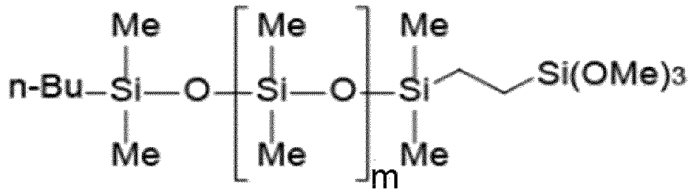
(2-1)

Here, the character of m is as described above.

The component (e-1) may be used alone or in combination of two or more thereof.

Examples of the (e-2) silicone oil include a straight silicone oil such as dimethyl silicone oil or phenylmethyl silicone oil, as well as a non-reactive modified silicone oil wherein a non-reactive organic group is introduced on a main chain with a polysiloxane structure, on a side chain bonded to the main chain, or at the end of the main chain. The non-reactive organic group is an organic group having no addition reactive group. Examples of the non-reactive modified silicone oil include a polyether modified-silicone oil, an aralkyl modified-silicone oil, a fluoroalkyl modified-silicone oil, a

long-chain alkyl modified-silicone oil, a higher fatty acid ester modified-silicone oil, a higher fatty acid amide modified-silicone oil, and a phenyl modified-silicone oil. Among the above silicone oils, a straight silicone oil is preferred, and among the straight silicone oils, dimethyl silicone oil is more preferred.

The (e-2) silicone oil may be used alone or in combination of two or more thereof.

The content of the component (e) in the silicone composition is, for example, 1% by mass or more and 50% by mass or less, based on the total amount of the organopolysiloxane in the silicone composition. The content of the component (e) of the above lower limit value or more makes the flexibility of the cured product obtained from the silicone composition to be easily increased and also makes the viscosity of the silicone composition to be easily decreased by the component (e). The content of the component (e) of the above upper limit or less can provide the silicone composition with a certain degree of curability to easily obtain a cured product with the desired physical properties, and bleeding out after curing is also easily prevented. The content of the component (e) in the silicone composition is preferably 2% by mass or more and 45% by mass or less, more preferably 4% by mass or more and 40% by mass or less, and even more preferably 6% by mass or more and 35% by mass or less.

<Component (f)>

The silicone compositions of the present invention may further comprise (f) a silane coupling agent. As the silane coupling agent, any known agent may be used without any particular limitation, and examples thereof can include dimethyldimethoxysilane, 3-acryloxypropyltrimethoxysilane, 3-methacryloxypropyltrimethoxysilane, vinyltrimethoxysilane, n-decyltrimethoxysilane, 3-isocyanatopropyltriethoxysilane, 3-(2-aminoethyl)aminopropyltrimethoxysilane, 3-mercaptopropyltrimethoxysilane, glycidoxypropyltrimethoxysilane and 3-phenylaminopropyltrimethoxysilane.

The silane coupling agent may be used alone or in combination of two or more thereof.

By including the (f) silane coupling agent in the silicone composition of the present invention, the filler is easily dispersed, so that the (c) thermally conductive filler can be highly filled and the thermal conductivity is high. The above described (c) thermally conductive filler may have been surface-treated with the component (f), and by surface-treating the (c) thermally conductive filler with the component (f), the dispersibility of the filler can be further improved.

The content of the silane coupling agent (f) in the silicone composition is, for example, 0.1 parts by mass or more and 10 parts by mass or less, and preferably 0.5 parts by mass or more and 5 parts by mass or less, relative to 100 parts by mass of the organopolysiloxane in the silicone composition.

The (f) silane coupling agent may or may not be used in combination with the above component (e).

<(g) Curing inhibitor>

The silicone composition may comprise (g) a curing inhibitor. The (g) curing inhibitor to be used can be any known addition reaction controlling agent that is used for an addition reaction-curing type silicone composition, and is not particularly limited. Examples thereof include an acetylenic compounds such as 1-ethynyl-1-hexanol, 1-ethynyl-2-cyclohexanol, 3-butyn-1-ol, 2-methyl-3-butyn-2-ol, ethynylmethylidenecarbinol or 3,5-dimethyl-1-hexyn-3-ol; a nitrogen compound, an organic phosphorus compound, an oxime compound, an organic chloro compound, and an organic sulfur compound. Of these, an acetylenic compound is preferred.

The content of the (g) curing inhibitor in the silicone composition is not particularly limited, but it is preferably 1 ppm by mass or more and 5,000 ppm by mass or less, more preferably 10 ppm by mass or more and 2,000 ppm by mass or less, and even more preferably 20 ppm by mass or more and 1,000 ppm by mass or less, based on the total amount of the silicone composition.

In the silicone composition of the present invention, the total content of the components (a) (b), and (e) is preferably 2% by mass or more and 40% by mass or less, relative to the total amount of the silicone composition. When the total content of the components (a) (b), and (e) is a certain amount or more, these components can properly fulfill their function as binder resins, and the (c) thermally conductive filler can be appropriately held by these components. When the above total content is a certain amount or less, a large amount of the (c) thermally conductive filler can be comprised. The total content of the components (a) (b), and (e) is more preferably 3% by mass or more and 30% by mass or less, even more preferably 3.5% by mass or more and 20% by mass or less, and still more preferably 4% by mass or more and 12% by mass or less, relative to the total amount of the silicone composition.

The organopolysiloxane in the silicone composition of the present invention may consist the components (a) and (b) or the components (a), (b) and (e), but may further comprise an organopolysiloxane other than the components (a), (b) and (e) as long as the effects of the present invention are not impaired.

Examples of the organopolysiloxane other than the components (a), (b) and (e) include an alkenyl group-containing organopolysiloxane other than the component (a), and the organohydrogenpolysiloxane other than the component (b).

Examples of the organohydrogenpolysiloxane other than the component (b) include an organohydrogenpolysiloxane, other than component (b), having Si-H at both the two molecular chain ends and the molecular-chain side chains (hereinafter also referred to as component (b2)). Specific examples of the component (b2) include an organohydrogenpolysiloxane having Si-H at both the two molecular chain ends and the molecular-chain side chains, the number of Si-H in the molecular-chain side chains being 3 or less or 16 or more.

However, it is preferable that the component (b2) is not comprised in the silicone composition or even if it is comprised, it is preferably comprised in a small amount. The content of the component (b2) in the silicone composition is, for example, 30% by mass or less, preferably 20% by mass or less, more preferably 10% by mass or less, and even more preferably 0% by mass, relative to 100% by mass of the component (b).

The silicone composition may also comprise an organohydrogenpolysiloxane (hereinafter also referred to as a component (b3)) other than an organohydrogenpolysiloxane having Si-H at both the two molecular chain ends and the molecular-chain side chains (that is, the components (b) and (b2)). Examples of the component (b3) include an organohydrogenpolysiloxane having Si-H only at the two molecular chain ends, an organohydrogenpolysiloxane having Si-H only at the one molecular chain end, and an organohydrogenpolysiloxane having Si-H at the one molecular chain end and at the molecular-chain side chain.

However, it is preferable that the silicone composition of the present invention comprises no organohydrogenpolysiloxane other than an organohydrogenpolysiloxane having Si-H at both the two molecular chain ends and the molecular-chain side chain, or even if the silicone composition comprises such an organohydrogenpolysiloxane, it comprises such an organohydrogenpolysiloxane in a small amount. Such a configuration makes it easier to achieve the effects of the present invention. Specifically, the organohydrogenpolysiloxane in the silicone composition preferably comprises an organohydrogenpolysiloxane having Si-H on both the two molecular chain ends and the molecular-chain side chain in a proportion of 70% by mass or more, more preferably 80% by mass or more, even more preferably 90% by mass or more, and most preferably 100% by mass. The organohydrogenpolysiloxane in the silicone composition preferably consists of the organohydrogenpolysiloxane having Si-H on both the two molecular chain ends and the molecular-chain side chains.

Examples of the alkenyl group-containing organopolysiloxane other than the component (a) include an organopolysiloxane having one alkenyl group in one molecule. However, it is preferable that the silicone composition of the present invention comprises no organopolysiloxane having an alkenyl group other than the component (a), or even if the silicone composition comprises such an organopolysiloxane, it comprises such an organopolysiloxane in a small amount. Specifically, it is preferable for 70% by mass or more of the alkenyl group-containing organopolysiloxane in the silicone composition to be the component (a), it is more preferable for 80% by mass or more thereof to be the component (a), and it is even more preferable for 90% by mass or more thereof to be the component (a), and it is preferable for 100% by mass thereof to be the component (a). That is, it is preferable for the alkenyl group-containing organopolysiloxane in the silicone composition consists of the component (a).

The silicone composition of the present invention can comprise various additives other than those described above. Examples of the additive include a dispersant, a flame retardant, a plasticizer, an antioxidant and a colorant. Each additive may be comprised in either the first agent or the second agent, or both. The additive to be used may be one or two or more selected appropriately from these additives.

<Ratio (H/Vi)>

The silicone composition of the present invention has a ratio (H/Vi) of the number of Si-H to the number of alkenyl groups in the silicone composition in the range of 0.5 or more and 1.5 or less. If the ratio (H/Vi) in the silicone composition is less than 0.5, the curability of the silicone composition decreases, making it difficult to properly cure the silicone. If the ratio (H/Vi) is more than 1.5, the curing may proceed too much, increasing the hardness of the cured product obtained after curing the silicone composition and decreasing the flexibility of the cured product. If the ratio (H/Vi) is outside the above range, the long-term reliability may be impaired, so that if the product is used for a long period of time in a high-temperature environment after curing, the hardness may increase, causing the cured product to be detached from a heat-generating element or heat-dissipating element and thereby resulting in an increase in thermal resistance value.

The ratio (H/Vi) is preferably 0.55 or more and 1.3 or less, more preferably 0.65 or more and 1.2 or less, and even more preferably 0.75 or more and 1.1 or less, from the viewpoint of ensuring the flexibility while suppressing an increase in hardness when used in a high-temperature environment, thereby improving the long-term reliability.

The number of alkenyl groups in the ratio (H/Vi) refers to the total number of alkenyl groups in all components in the silicone composition. The number of alkenyl groups in each component can be calculated from the amount of functional groups (mmol/g) in each component and the content of each component. The same applies to the number of Si-H.

<Type E hardness>

The silicone composition of the present invention preferably has a type E hardness of less than 70 for a cured product obtained by curing the silicone composition. When the type E hardness is less than 70, the cured product obtained from the silicone composition is flexible. Therefore, the obtained cured product is prevented from being detached from a heat-dissipating element or heat-generating element, resulting in a high thermal resistance and a high stress on the surrounding electronic components. The type E hardness of the cured product obtained by curing the silicone composition is more preferably less than 60 and even more preferably less than 50.
In addition, the type E hardness of the cured product obtained by curing the silicone composition is preferably 10 or more. When the type E hardness is a certain value or more, for example, the weight of a member installed on top of the cured product can be sufficiently supported, and the cured product can be prevented from being compressed in the thickness direction during use.
The type E hardness may be measured for the cured product obtained by curing the silicone composition by the method described in the Examples.

<Two-part curing type>

In the present invention, the silicone composition is a two-part curing type that is composed of a combination of a first agent and a second agent. The two-part curing type silicone composition can be obtained by mixing the first agent and the second agent.
In the two-part curing type silicone composition, the mass ratio of the second agent to the first agent (the second agent/the first agent) is preferably 1 or a value close to 1, and is preferably 0.8 or more and 1.2 or less, more preferably 0.9 or more and 1.1 or less, and even more preferably 0.95 or more and 1.05 or less. When the mass ratio of the second agent to the first agent is such a value of 1 or close to 1, the silicone composition is easily prepared.
It is preferred that the first agent and the second agent are each stored in separate containers, and are taken out of the containers and mixed immediately before use. The container is not particularly limited, but it may be a syringe or the like. By using a syringe, the first agent and the second agent dispensed from each syringe can be easily mixed. As described above, the first agent and the second agent can be easily mixed at a mass ratio of 1 or a mass ratio close to 1. It is preferred that the first agent and the second agent are flowable at room temperature (23°C). When the first agent and the second agent are flowable at room temperature, the handleability is improved.
In the two-part curing type silicone composition, it is preferred that the first agent and the second agent are each prepared so that the reaction does not substantially proceed before they are mixed. Specifically, in the two-part curing type silicone composition, the first agent comprises the component (a) that is an organopolysiloxane having an alkenyl group (alkenyl group-containing organopolysiloxane) and the (d) curing catalyst, but does not comprise the component (b) that is an organohydrogenpolysiloxane. The second agent comprises the component (b) that is an organohydrogenpolysiloxane, but does not comprise the (d) curing catalyst.
In the present invention, the (c) thermally conductive filler is further comprised in both the first agent and the second agent, and the component (a) is also comprised in the second agent.
Since the first agent having the above configuration comprises the (d) curing catalyst which promotes the addition reaction, but does not comprise the component (b), the addition reaction can be prevented from proceeding before the first agent is mixed with the second agent. On the other hand, since the second agent comprises the components (a) and (b), but does not comprise the (d) curing catalyst that promotes the addition reaction, the addition reaction can be prevented from proceeding before the second agent is mixed with the first agent.
In addition, in the present invention, by including the components (a) and (c) in both the first agent and the second agent, the specific gravity and viscosity of the first agent and the second agent can be made approximately the same, and the miscibility of the first agent and the second agent can be thereby improved. Furthermore, the mass ratio between the first agent and the second agent is easily adjusted to 1 or close to 1. Details of the components (a) and (c) comprised in each of the first agent and the second agent are as described above, but the component (a) comprised in the first agent may be the same as or different from the component (a) comprised in the second agent. The same applies to the component (c), and further to the components (e), (f), and (g) described below.

(Viscosity difference between components (a) and (b))

In the present invention, the difference in viscosity at 23°C between the components (a) and (b) in the second agent is 400 mPa·s or less. If the viscosity difference exceeds 400 mPa·s, the components (a) and (b) are less compatible, and oil bleeding occurs in the second agent during storage or the like, resulting in a decrease in storage stability. From the viewpoint of making oil bleeding less likely to occur, the above viscosity difference is preferably 350 mPa·s or less, and more preferably 300 mPa·s or less. From the viewpoint of reducing oil bleeding, the lower the viscosity difference, the

better, and it is sufficient if it is 0 mPa·s or more. When two or more components (a) different in viscosity are comprised in the second agent, the viscosity of the component (a) refers to the viscosity of the mixture. The same applies to the viscosity of the component (b).

In the two-part curing type silicone composition, it is preferred that the total content of the components (a) and (b) in the second agent is adjusted so as to be approximately the same as the content of the component (a) in the first agent. When these contents are approximately the same, in combination with the small difference in viscosity between the components (a) and (b), the viscosities of the first agent and the second agent are easily made approximately the same. In addition, the specific gravities of the first agent and the second agent are easily made approximately the same, and the miscibility of the first agent and the second agent can be thereby improved. Furthermore, the mass ratio between the first agent and the second agent is easily adjusted to 1 or close to 1.

Specifically, the mass ratio ((a2+b2)/a1) of the total content of the components (a) and (b) in the second agent to the content of the component (a) in the first agent is preferably 0.8 or more and 1.2 or less, more preferably 0.9 or more and 1.1 or less, and even more preferably 0.95 or more and 1.05 or less.

It is preferred that the second agent comprises a certain amount or more of the component (a) so that the mass ratio ((a2+b2)/a1) is 1 or close to 1 as described above. Specifically, the component (a) may be blended in the first agent and the second agent so that the ratio (a2/a1) of the content of the component (a) in the second agent to the content of the component (a) in the first agent is, for example, 0.1 or more, preferably 0.2 or more, and more preferably 0.35 or more. In the present invention, even when the second agent comprises a certain amount or more of the component (a) in this way, the occurrence of oil bleeding is suppressed by adjusting the viscosity of the components (a) and (b), and a decrease in storage stability caused by blending the component (a) into the second agent can be therefore suppressed.

The ratio (a2/a1) is not particularly limited, but it is, for example, 2 or less, preferably less than 1 and more preferably 0.95 or less.

The mass ratio (a2/b2) of the component (a) to the component (b) in the second agent is not particularly limited, but it is, for example, 0.4 or more and 15 or less, preferably 0.5 or more and 10 or less, and more preferably 0.75 or more and 8 or less.

The first agent and the second agent for forming the silicone composition preferably comprise the (c) thermally conductive filler approximately equally. Specifically, the mass ratio (c2/c1) of the content of the (c) thermally conductive filler in the second agent to the content of the (c) thermally conductive filler in the first agent is preferably 0.8 or more and 1.2 or less, more preferably 0.9 or more and 1.1 or less, and even more preferably 0.95 or more and 1.05 or less. In this way, by distributing the (c) thermally conductive filler approximately equally in the first agent and the second agent, the difference in specific gravity and the difference in viscosity between the first agent and the second agent are made easily decreased, and the mass ratio between the first agent and the second agent is also easily adjusted close to 1.

The silicone composition may comprise, in addition to the component (b), an organohydrogenpolysiloxane. In such a case, it is preferred that such an organohydrogenpolysiloxane is entirely comprised in the second agent and it is not comprised in the first agent. Such a configuration can prevent the addition reaction from proceeding in the first agent.

On the other hand, the silicone composition may comprise, in addition to the component (a), an alkenyl group-containing organopolysiloxane. The alkenyl group-containing organopolysiloxane other than the component (a) may be comprised in the first agent, the second agent, or both the first agent and the second agent.

The silicone composition preferably comprises the component (e). It is preferred that at least one of the first agent and the second agent comprises the component (e), and it is more preferred that both the first agent and the second agent comprises the component (e). When both the first agent and the second agent comprise the component (e), the viscosity of the first agent and the second agent can be adjusted by the component (e) so that both the first agent and the second agent have a relatively low viscosity.

The silicone composition may comprise the component (f) (a silane coupling agent). It is preferred that at least one of the first agent and the second agent comprises the component (f), but it is more effective and more preferable that both the first agent and the second agent comprise the component (f).

That is, when the silicone composition comprises the component (f) (a silane coupling agent) or the component (e-1), each of the first agent and the second agent preferably comprises at least one of the component (f) or the component (e-1) in addition to the (c) thermally conductive filler.

The silicone compositions may comprise the component (g) (a curing inhibitor). Either or both of the first agent and the second agent may comprise the component (g), but at least the second agent preferably comprises the curing agent. The second agent comprises both an organohydrogenpolysiloxane (for example, component (b)) and an alkenyl group-containing organopolysiloxane (for example, component (a)), but the reactions therebetween can be prevented from proceeding in the second agent by further including (g) a reaction controlling agent in the second agent.

In the preparation of a two-part curing type silicone composition, it is preferred that each of the first agent and the second agent is prepared by mixing all the components constituting each of the first agent or the second agent. In this case, the order of blending the components constituting each of the first agent or the second agent is not particularly limited. However, when the (c) thermally conductive filler is to be surface-treated with an organosilicon compound having a

hydrolyzable silyl group such as the component (e-1) or the component (f), it is preferred that in the preparation of the first agent and the second agent, the organosilicon compound having a hydrolyzable silyl group such as the component (e-1) or the component (f) is first mixed with the (c) thermally conductive filler to allow the component (e-1) or the component (f) to adhere to or react with the surface of the (c) thermally conductive filler, and other components are then further mixed.

With respect to the second agent, the component (c) which has been surface-treated as necessary as described above is preferably first mixed with the component (a) with stirring to sufficiently disperse them and cooled, followed by the addition of the component (b). When stirring the component (c), the temperature may increase and heating may be sometimes carried out with stirring in order to increase the dispersibility. However, by mixing the component (a) and the component (c) before mixing the component (b) therein as described above, the component (b) can be prevented from reacting due to heat generation or heating during stirring the component (c).

[Heat-dissipating member]

The silicone composition of the present invention can be used as a raw material to produce a heat-dissipating member formed by the silicone composition. For example, the silicone composition can be formed into a predetermined shape and then appropriately cured by heating or the like to produce a heat-dissipating member shaped into a predetermined shape. The heat-dissipating member is interposed between a heat-generating element and a heat-dissipating element, and transfers the heat generated by the heat-generating element to the heat-dissipating element by thermal conduction to dissipate the heat from the heat-dissipating element. Examples of the heat-generating element include various electronic components used inside electronic devices such as a CPU, a power amplifier and a power supply. Examples of the heat-dissipating element include a heat sink, a heat pump and a metal housing of electronic devices.

The heat-dissipating member can be used inside an electronic device to provide an electronic device comprising an electronic component and a heat-dissipating member disposed on the electronic component. Specifically, the heat-dissipating member can be disposed between an electronic component such as a semiconductor device and a heat-dissipating element such as a heat sink to effectively dissipate the heat generated from the electronic component.

Examples

Hereinafter, the present invention will be clearly described with reference to the specific examples and the comparative examples of the present invention. However, the present invention is not limited to the following Examples.

The measurement method and evaluation method for each of physical properties are as follows.

[Viscosity]

The viscosity was measured at 23°C with a Brookfield Type B viscometer. The measurement was carried out with "HB DVE" manufactured by EKO INSTRUMENTS CO., LTD., as a measuring apparatus. The rotation speed was set to 10 rpm, and the value measured 3 minutes after the start of rotation was taken as the viscosity. In the measurement with the B-type viscometer, the spindle was appropriately selected so that the torque was 10 to 80%.

[Coefficient of Thermal Conductivity]

The coefficient of thermal conductivity was measured at 23°C for the silicone composition before curing, in accordance with ASTM D5470. The measurement was carried out with "T3 Ster DynTIM Tester" available from Mentor, a Siemens Business, as measuring apparatus, and the evaluation was carried out according to the following criteria.

OK: 3 W/m·K or more
NG: less than 3 W/m·K

[Hardness measurement]

The hardness was measured at 25°C with an automatic hardness measuring apparatus, "GX-02E", Type E manufactured by TECLOCK Co., Ltd. The cured products obtained in each Example and Comparative Example were subjected to the measurement of the initial hardness and was evaluated according to the following criteria.

A: Hardness of 10 or more and less than 50
B: Hardness of 50 or more and less than 70
C: Hardness of 70 or more

[Oil bleeding (Separation during storage)]

Each of the first agent and second agent of the silicone composition was filled into a 30 ml syringe. Each syringe was stored in an oven set at 50°C, and 2 weeks later, each liquid was checked for oil bleeding.

[Long-term reliability]

Each of the silicone compositions obtained in each Example and Comparative Example was applied onto a copper block having 25.4 mm × 25.4 mm in size, sandwiched between this block and another copper block, and a 1 mm spacer was used to ensure that the thickness was uniform. The silicone composition was allowed to stand at room temperature (23°C) for 24 hours for curing. The thermal resistance value of the silicone composition after curing was measured and was taken as the initial thermal resistance value. Thereafter, it was heated in an oven at 150°C for 250 hours, the thermal resistance value thereof was measured, and the rate of change in the thermal resistance value was calculated according to the following equation. The rate of change in the thermal resistance value was evaluated according to the evaluation criteria described below.

Rate of change in thermal resistance value (%) = [thermal resistance value after heating/initial thermal resistance value] × 100

The thermal resistance value was measured as follows. A heater was installed on one side of the copper block, and a heat sink with a fan was installed on another side thereof. The heater was used to generate heat, and when the temperature reached a constant temperature, the temperature on one side (T1) and the temperature on another side (T2) and the amount of heat generated (Q) were measured, and the thermal resistance value was calculated according to the following equation.

$$\text{Thermal resistance value} = (T1 - T2) / Q$$

A: 100% or more and less than 125%
B: 125% or more and less than 150%
C: 150% or more

The components used in each Example and Comparative Example are as follows. The vinyl group content of the alkenyl group-containing organopolysiloxane and the SiH content of the organohydrogenpolysiloxane are as shown in the column of "amount of functional groups" in Tables 1 and 2. The viscosity of each component at 23°C is also shown in Tables 1 and 2.

[Alkenyl group-containing organopolysiloxane]

<Component (a)>

A-1: Organopolysiloxane, having vinyl groups only at the two molecular chain ends, represented by formula (A): the number of vinyl groups in one molecule = 2
A-2: Organopolysiloxane, having vinyl groups only at the two molecular chain ends, represented by formula (A): the number of vinyl groups in one molecule = 2
A-3: Organopolysiloxane, having vinyl groups only at the two molecular chain ends, represented by formula (A): the number of vinyl groups in one molecule = 2
A-4: Organopolysiloxane, having vinyl groups only at the two molecular chain ends, represented by formula (A): the number of vinyl groups in one molecule = 2
A-5: Organopolysiloxane, having vinyl groups only at the two molecular chain ends, represented by formula (A): the number of vinyl groups in one molecule = 2

[Organohydrogenpolysiloxane]

<Component (b)>

B-1: Organohydrogenpolysiloxane, having Si-H at both the two molecular chain ends and the molecular-chain side chains, represented by formula (B): the number of Si-H in one molecule = 6 (2 at the ends, 4 at the side chains)
B-2: Organohydrogenpolysiloxane, having Si-H at both the two molecular chain ends and the molecular-chain side chains, represented by formula (B): the number of Si-H in one molecule = 12 (2 at the ends, 10 at the side chains)
B-3: Organohydrogenpolysiloxane, having Si-H at both the two molecular chain ends and the molecular-chain side chains, represented by formula (B): the number of Si-H in one molecule = 17 (2 at the ends, 15 at the side chains)
B-4: Organohydrogenpolysiloxane, having Si-H at both the two molecular chain ends and the molecular-chain side chains, represented by formula (B): the number of Si-H in one molecule = 12 (2 at the ends, 10 at the side chains)

<Component (b2)>

B2-1: Organohydrogenpolysiloxane, having Si-H at both the two molecular chain ends and the molecular-chain side chains: the number of Si-H in one molecule = 22 (2 at the ends, 20 at the side chains)

<Component (b3)>

B3-1: Organohydrogenpolysiloxane having Si-H only at the molecular-chain side chains: the number of Si-H in one molecule = 10 (10 at the side chains)

[Thermally conductive filler]

C-1: Alumina 1 (average particle diameter of primary particles: 3 μm)
C-2: Alumina 2 (average particle diameter of primary particles: 0.5 μm)
C-3: Aluminum nitride (average particle diameter of primary particles: 10 μm)
C-4: Diamond (average particle diameter of primary particles: 12 μm)

[Curing catalyst]

D-1: Platinum-based catalyst

[Addition reactive group-containing organopolysiloxane]

E-1: Compound represented by formula (1-1) wherein n is 10 to 11.

[Curing inhibitor]

G-1: Curing inhibitor, 3,5-dimethyl-1-hexyn-3-ol

[Examples 1 to 11 and Comparative Examples 1 to 5]

Each of first agent and second agent was prepared according to each of the formulations shown in Table 1. The obtained first agent and second agent were mixed with a stirrer to obtain a silicone composition. The obtained silicone composition was cured at room temperature for 24 hours to obtain a cured product. The obtained cured product was used and evaluated for the initial hardness and the oil bleeding. The obtained silicone composition was also used and evaluated for the coefficient of thermal conductivity and the long-term reliability. The evaluation results are shown in Table 1.

[Table 1]

| | | | | Viscosity (mPa·s) | Amount of functional groups (mmol/g) | Examples | | | | | | | | | | | | | | | |
|---|---|---|---|---|---|---|---|---|---|---|---|---|---|---|---|---|---|---|---|---|---|
| | | | | | | 1 | | 2 | | 3 | | 4 | | 5 | | 6 | | 7 | | 8 | |
| | | | | | | First agent | Second agent | First agent | Second agent | First agent | Second agent | First agent | Second agent | First agent | Second agent | First agent | Second agent | First agent | Second agent | First agent | Second agent |
| Formulation (parts by mass) | Alkyl group-containing organopolysiloxane | A-1 | Vinyl at two ends | 100 | 0.4 | 45.2 | 20.2 | 44.6 | 31.6 | | | | | | | | | 42.5 | 25.5 | 44.6 | 28.6 |
| | | A-2 | Vinyl at two ends | 200 | 0.28 | | | | | 45.2 | 35.8 | | | | | | | | | | |
| | | A-3 | Vinyl at two ends | 350 | 0.18 | | | | | | | 45.2 | 40.5 | 45.2 | 35.8 | | | | | | |
| | | A-4 | Vinyl at two ends | 450 | 0.15 | | | | | | | | | | | 43.8 | 39.3 | | | | |
| | | A-5 | Vinyl at two ends | 600 | 0.11 | | | | | | | | | | | | | | | | |
| | Organohydrogenpolysiloxane | B-1 | SiH at both two ends and side chains (at side chains 4) | 110 | 0.95 | | 24.9 | | | | | | | | | | | | 17.0 | | |
| | | B-2 | SiH at both two ends and side chains (at side chains 10) | 120 | 2.21 | | | | 13.0 | | 9.3 | | | | | | | | | | 16.1 |
| | | B-3 | SiH at both two ends and side chains (at side chains 15) | 110 | 3.05 | | | | | | | | 4.7 | | | | | | | | |
| | | B-4 | SiH at both two ends and side chains (at side chains 10) | 50 | 1.6 | | | | | | | | | | 9.3 | | 7.6 | | | | |
| | | B2-1 | SiH at both two ends and side chains (at side chains 20) | 100 | 4.03 | | | | | | | | | | | | | | | | |
| | | B3-1 | SiH at side chains (at side chains 10) | 105 | 1.93 | | | | | | | | | | | | | | | | |
| | Thermally conductive filler | C-1 | Alumina 1 (average particle diameter 3 μm) | | | 561 | 561 | 595 | 595 | 561 | 561 | 545 | 545 | 545 | 545 | 529 | 529 | 637 | 637 | 607 | 607 |
| | | C-2 | Alumina 2 (average particle diameter 0.5 μm) | | | | | | | | | | | | | | | | | | |
| | | C-3 | AlN (average particle diameter 10 μm) | | | | | | | | | | | | | | | | | | |
| | | C-4 | Diamond (average particle diameter 12 μm) | | | | | | | | | | | | | | | | | | |
| | Organopolysiloxane containing no addition reactive group | E-1 | Trialkoxysilyl group-containing at one end | | | 4.8 | 4.8 | 5.4 | 5.4 | 4.8 | 4.8 | 4.8 | 4.8 | 4.8 | 4.8 | 4.7 | 4.7 | 7.6 | 7.4 | 5.4 | 5.4 |
| | Platinum-based catalyst | D-1 | | | | 10 ppm | | 10 ppm | | 10 ppm | | 10 ppm | | 10 ppm | | 10 ppm | | 10 ppm | | 10 ppm | |
| | Curing inhibitor | G-1 | | | | | 200 ppm | | 200 ppm | | 200 ppm | | 200 ppm | | 200 ppm | | 200 ppm | | 200 ppm | | 200 ppm |
| Content · Physical properties | Amount of thermally conductive filler (parts by mass) | | | | | 1121 | | 1190 | | 1121 | | 1090 | | 1090 | | 1057 | | 1274 | | 1214 | |
| | H/Vi | | | | | 0.90 | | 0.94 | | 0.91 | | 0.92 | | 1.03 | | 0.97 | | 0.59 | | 1.21 | |
| | Difference in viscosity between (a) and (b) (mPa·s) | | | | | - | 10 | - | 20 | - | 20 | - | 240 | - | 300 | - | 400 | - | 10 | - | 20 |
| Evaluation | Coefficient of thermal conductivity | | | | | OK | | OK | | OK | | OK | | OK | | OK | | OK | | OK | |
| | Hardness | | | | | A | | A | | A | | B | | B | | A | | A | | B | |
| | Oil bleeding (Separation) | | | | | No | No | No | No | No | No | No | No | No | No | No | No | No | No | No | No |
| | Long-term reliability (Thermal resistance value) | | | | | A | | A | | A | | B | | A | | A | | B | | B | |

[Table 2]

| | | | | Viscosity (mPa·s) | Amount of functional groups (mmol/g) | Examples | | | | | | Comparative Examples | | | | | | | | | |
|---|---|---|---|---|---|---|---|---|---|---|---|---|---|---|---|---|---|---|---|---|---|
| | | | | | | 9 | | 10 | | 11 | | 1 | | 2 | | 3 | | 4 | | 5 | |
| | | | | | | First agent | Second agent | First agent | Second agent | First agent | Second agent | First agent | Second agent | First agent | Second agent | First agent | Second agent | First agent | Second agent | First agent | Second agent |
| Formulation (parts by mass) | Alkyl group-containing organopolysiloxane | A-1 | Vinyl at two ends | 100 | 0.4 | 44.3 | 21.3 | 44.3 | 21.3 | 44.2 | 21.3 | 44.7 | 36.4 | 44.7 | 29.8 | | | 43.9 | 32.2 | 44.1 | 23.1 |
| | | A-2 | Vinyl at two ends | 200 | 0.28 | | | | | | | | | | | | | | | | |
| | | A-3 | Vinyl at two ends | 350 | 0.18 | | | | | | | | | | | | | | | | |
| | | A-4 | Vinyl at two ends | 450 | 0.15 | | | | | | | | | | | | | | | | |
| | | A-5 | Vinyl at two ends | 600 | 0.11 | | | | | | | | | | | 44.7 | 36.4 | | | | |
| | Organohydrogenpolysiloxane | B-1 | SiH at both two ends and side chains (at side chains 4) | 110 | 0.95 | | 24.6 | | 24.6 | | 24.5 | | | | | | 8.3 | | 11.7 | | |
| | | B-2 | SiH at both two ends and side chains (at side chains 10) | 120 | 2.21 | | | | | | | | | | | | | | | | 20.9 |
| | | B-3 | SiH at both two ends and side chains (at side chains 15) | 110 | 3.05 | | | | | | | | | | | | | | | | |
| | | B-4 | SiH at both two ends and side chains (at side chains 10) | 50 | 1.6 | | | | | | | | | | | | | | | | |
| | | B2-1 | SiH at both two ends and side chains (at side chains 20) | 100 | 4.03 | | | | | | | | 8.3 | | | | | | | | |
| | | B3-1 | SiH at side chains (at side chains 10) | 105 | 1.93 | | | | | | | | | | 14.9 | | | | | | |
| | Thermally conductive filler | C-1 | Alumina 1 (average particle diameter 3 μm) | | | | | | | 507 | 507 | 613 | 613 | 579 | 579 | 579 | 579 | 643 | 643 | 639 | 639 |
| | | C-2 | Alumina 2 (average particle diameter 0.5 μm) | | | | | | | 65 | 65 | | | | | | | | | | |
| | | C-3 | AlN (average particle diameter 10 μm) | | | 525 | 525 | | | | | | | | | | | | | | |
| | | C-4 | Diamond (average particle diameter 12 μm) | | | | | 508 | 508 | | | | | | | | | | | | |
| | Organopolysiloxane containing no addition reactive group | E-1 | Trialkoxysilyl group-containing at one end | | | 4.9 | 4.9 | 4.9 | 4.9 | 5.1 | 4.9 | 5.3 | 5.3 | 5.3 | 5.3 | 5.3 | 5.3 | 6.1 | 6.1 | 5.9 | 5.9 |
| | Platinum-based catalyst | D-1 | | | | 10 ppm | | 10 ppm | | 10 ppm | | 10 ppm | | 10 ppm | | 10 ppm | | 10 ppm | | 10 ppm | |
| | Curing inhibitor | G-1 | | | | | 200 ppm | | 200 ppm | | 200 ppm | | 200 ppm | | 200 ppm | | 200 ppm | | 200 ppm | | 200 ppm |
| Content · Physical properties | Amount of thermally conductive filler (parts by mass) | | | | | 1049 | | 1016 | | 1146 | | 1225 | | 1159 | | 1159 | | 1287 | | 1278 | |
| | H/Vi | | | | | 0.89 | | 0.89 | | 0.89 | | 1.03 | | 0.97 | | 0.88 | | 0.37 | | 1.72 | |
| | Difference in viscosity between (a) and (b) (mPa·s) | | | | | - | 10 | - | 10 | - | 10 | - | 0 | - | 5 | - | 490 | - | 10 | - | 20 |
| Evaluation | Coefficient of thermal conductivity | | | | | OK | | OK | | OK | | OK | | OK | | OK | | OK | | OK | |
| | Hardness | | | | | A | | A | | A | | C | | C | | A | | Not cured | | C | |
| | Oil bleeding (Separation) | | | | | No | No | No | No | No | No | No | No | No | No | No | Yes | No | No | No | No |
| | Long-term reliability (Thermal resistance value) | | | | | A | | A | | A | | C | | C | | A | | Not cured | | C | |

* In Tables 1 and 2, the amount (ppm) of each of the platinum-based catalyst and the curing inhibitor is expressed in ppm by mass relative to the silicone composition. The amount of each of the other components is expressed in parts by mass of each component relative to 100 parts by mass of the organopolysiloxane in the silicone composition.

Each of the silicone compositions of Examples 1 to 11 as described above comprised the components (a) to (d), and the ratio of the number of SiH to the number of alkenyl groups (H/Vi) was within a predetermined range. Therefore, despite of its high coefficient of thermal conductivity and good thermal conductivity, the composition was low in initial hardness and was flexible, and even after heated at 150°C for a long period of time after cured, an increase in the thermal resistance value was small and the long-term reliability was good. In addition, although the component (a) and the component (b) were comprised in the second agent, oil bleeding did not occur in the second agent during storage, because the difference in viscosity between the component (a) and the component (b) was 400 mPa·s or less.

In contrast, since each of the silicone compositions of Comparative Examples 1 and 2 did not comprise the specific component (b), the flexibility could not be improved and the long-term reliability was also low. In Comparative Example 3, due to the difference in viscosity between the component (a) and the component (b) of more than 400 mPa·s, oil bleeding occurred in the second agent. In Comparative Example 4, due to too low ratio (H/Vi), curing was poor, while in Comparative Example 5, due to too high ratio (H/Vi), curing proceeded too much, the hardness increased and the long-term reliability also deteriorated.

## Claims

**1.** A silicone composition comprising:

(a) an organopolysiloxane having at least two alkenyl groups in one molecule;
(b) an organohydrogenpolysiloxane having hydrogen atoms directly bonded to silicon atoms at both two molecular chain ends and molecular-chain side chains, the number of the hydrogen atoms in the molecular-chain side chains being 4 to 15;
(c) a thermally conductive filler; and
(d) a curing catalyst;
the silicone composition comprising: a combination of a first agent comprising the components (a), (c) and (d) and not comprising the component (b) ; and a second agent comprising the components (a), (b) and (c) and not comprising the component (d);
a difference in viscosity at 23°C between the components (a) and (b) in the second agent is 400 mPa·s or less; and a ratio of the number of hydrogen atoms directly bonded to silicon atoms to the number of alkenyl groups (H/Vi) is in the range of 0.5 or more and 1.5 or less.

**2.** The silicone composition according to claim 1, comprising an organosilicon compound having a hydrolyzable silyl group at the molecular chain end.

**3.** The silicone composition according to claim 1 or 2, comprising at least one selected from the group consisting of (e) an organopolysiloxane having no addition reactive group and (f) a silane coupling agent.

**4.** The silicone composition according to claim 3, wherein each of the first agent and the second agent comprises at least one selected from the group consisting of the components (e) and (f).

**5.** The silicone composition according to claim 3, comprising, as the component (e), (e-1) an organopolysiloxane having a hydrolyzable silyl group at a molecular chain end.

**6.** The silicone composition according to claim 3, comprising, as the component (e), at least one compound selected from the group consisting of a compound represented by the following formula (1) and a compound represented by the following formula (2):

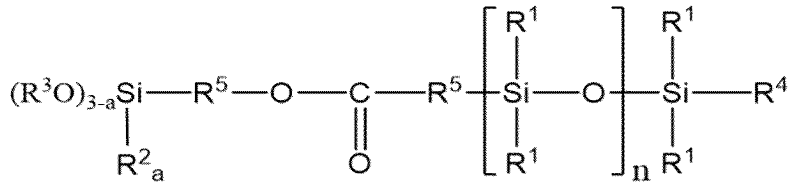

(1)

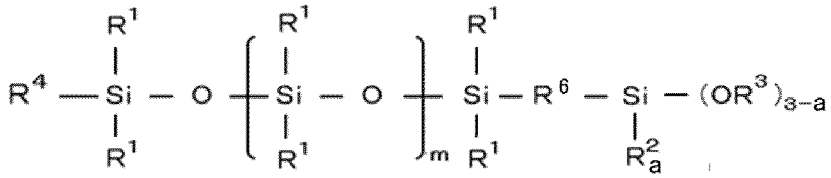

(2)

wherein:

in each of the formulas (1) and (2), each $R^1$ is independently any one of an alkyl group having 1 to 20 carbon atoms, a halogenated alkyl group having 1 to 20 carbon atoms, an aryl group having 6 to 20 carbon atoms and an aralkyl group having 7 to 20 carbon atoms, and the multiple $R^1$s in each formula may be each the same or different; each $R^2$ is independently an alkyl group having 1 to 4 carbon atoms, and when multiple $R^2$s are present in each formula, the multiple $R^2$s may be each the same or different; each $R^3$ is independently any one of an alkyl group having 1 to 4 carbon atoms, an alkoxyalkyl group having 2 to 4 carbon atoms and an acyl group having 2 to 4 carbon atoms, and when multiple $R^3$s are present in each formula, the multiple $R^3$s may be each the same or different; and each $R^4$ is independently an alkyl group having 1 to 8 carbon atoms;
in the formula (1), each $R^5$ is independently a divalent hydrocarbon group having 2 to 20 carbon atoms, and the multiple $R^5$s may be each the same or different;
in the formula (2), $R^6$ is an oxygen atom or a divalent hydrocarbon group having 2 to 20 carbon atoms;
in each of the formulas (1) and (2), a is an integer from 0 to 2;
in the formula (1), n is an integer from 4 to 150; and
in the formula (2), m is an integer from 15 to 315.

7. The silicone composition according to claim 1 or 2, wherein a viscosity at 23°C of the component (a) is 20 m·Pa or more and 100,000 m·Pa or less.

8. The silicone composition according to claim 1 or 2, wherein a content of the (c) thermally conductive filler is 1,000 parts by mass or more and 4,000 parts by mass or less relative to 100 parts by mass of the organopolysiloxane in the silicone composition.

9. The silicone composition according to claim 1 or 2, wherein a content of the (d) curing catalyst is 0.1 ppm by mass or more and 500 ppm by mass or less.

10. The silicone composition according to claim 1 or 2, wherein the second agent comprises (g) a curing inhibitor.

11. The silicone composition according to claim 1 or 2, wherein the organohydrogenpolysiloxane in the silicone composition consists of an organohydrogenpolysiloxane having hydrogen atoms directly bonded to the silicon atoms at both the two molecular chain ends and the molecular-chain side chains.

12. The silicone composition according to claim 1 or 2, wherein the (c) thermally conductive filler is at least one selected from the group consisting of an oxide, a nitride, a carbide, a carbon-based material and a metal hydroxide.

13. The silicone composition according to claim 1 or 2, wherein the (c) thermally conductive filler is at least one selected from the group consisting of alumina, diamond and aluminum nitride.

14. The silicone composition according to claim 1 or 2, wherein primary particles of the (c) thermally conductive filler have an average particle diameter of 0.1 μm or more.

15. The silicone composition according to claim 1 or 2, wherein the (c) thermally conductive filler comprises two or more types of particles different in average particle diameters of the primary particles.

**16.** The silicone composition according to claim 1 or 2, wherein a cured product obtained by curing the silicone composition has a type E hardness of less than 70.

**17.** A heat-dissipating member formed from the silicone composition according to claim 1 or 2.

**18.** An electronic device comprising an electronic component and the heat-dissipating member according to claim 17 disposed on the electronic component.

**INTERNATIONAL SEARCH REPORT**

International application No. **PCT/JP2023/022390**

**A. CLASSIFICATION OF SUBJECT MATTER**

***C08L 83/07***(2006.01)i; ***C08K 3/011***(2018.01)i; ***C08K 3/013***(2018.01)i; ***C08L 83/05***(2006.01)i; ***C08L 83/06***(2006.01)i; ***H01L 23/373***(2006.01)i

FI: C08L83/07; C08K3/013; C08L83/05; C08L83/06; C08K3/011; H01L23/36 M

According to International Patent Classification (IPC) or to both national classification and IPC

**B. FIELDS SEARCHED**

Minimum documentation searched (classification system followed by classification symbols)

C08L83/07; C08K3/011; C08K3/013; C08L83/05; C08L83/06; H01L23/373

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | CN 110746926 A (YANGZHOU HONGYUAN NEW MATERIALS CO., LTD.) 04 February 2020 (2020-02-04) examples 1-3, table 1 | 1-18 |
| A | JP 2020-63380 A (SHIN-ETSU CHEMICAL CO., LTD.) 23 April 2020 (2020-04-23) examples 2, 6, table 2 | 1-18 |
| A | JP 2019-182980 A (SHIN-ETSU CHEMICAL CO., LTD.) 24 October 2019 (2019-10-24) examples 1-5, table 1 | 1-18 |
| A | JP 2018-27997 A (SHIN-ETSU CHEMICAL CO., LTD.) 22 February 2018 (2018-02-22) examples 1-4, table 1 | 1-18 |
| A | JP 2016-98337 A (SHIN-ETSU CHEMICAL CO., LTD.) 30 May 2016 (2016-05-30) example 3, table 1 | 1-18 |
| A | WO 2020/262449 A1 (MOMENTIVE PERFORMANCE MATERIALS JAPAN LLC) 30 December 2020 (2020-12-30) examples 1-5, table 1 | 1-18 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 August 2023** | **29 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2023/022390**

**C. DOCUMENTS CONSIDERED TO BE RELEVANT**

| Category* | Citation of document, with indication, where appropriate, of the relevant passages | Relevant to claim No. |
|---|---|---|
| A | WO 2018/221662 A1 (MOMENTIVE PERFORMANCE MATERIALS JAPAN LLC) 06 December 2018 (2018-12-06) examples 1-6, table 1 | 1-18 |
| A | CN 109504340 A (YANTAI DARBOND TECHNOLOGY CO., LTD.) 22 March 2019 (2019-03-22) example 2 | 1-18 |
| A | CN 109504341 A (YANTAI DARBOND TECHNOLOGY CO., LTD.) 22 March 2019 (2019-03-22) example 1 | 1-18 |
| A | CN 101985519 A (YANTAI DARBOND ELECTRONIC MATERIAL CO., LTD.) 16 March 2011 (2011-03-16) example 4 | 1-18 |

Form PCT/ISA/210 (second sheet) (January 2015)

**INTERNATIONAL SEARCH REPORT**
**Information on patent family members**

International application No.
**PCT/JP2023/022390**

| Patent document cited in search report | Publication date (day/month/year) | Patent family member(s) | Publication date (day/month/year) |
|---|---|---|---|
| CN 110746926 A | 04 February 2020 | (Family: none) | |
| JP 2020-63380 A | 23 April 2020 | (Family: none) | |
| JP 2019-182980 A | 24 October 2019 | WO 2019/198424 A1<br>TW 201943768 A | |
| JP 2018-27997 A | 22 February 2018 | US 2018/0051199 A1<br>examples 1-4, table 1<br>TW 201821544 A | |
| JP 2016-98337 A | 30 May 2016 | US 2017/0260392 A1<br>example 3, table 1<br>WO 2016/084520 A1<br>EP 3225662 A1<br>TW 201623456 A<br>CN 107001802 A<br>KR 10-2017-0090440 A | |
| WO 2020/262449 A1 | 30 December 2020 | US 2022/0267533 A1<br>examples 1-5, table 1<br>EP 3992250 A1<br>CN 114008141 A<br>TW 202108676 A | |
| WO 2018/221662 A1 | 06 December 2018 | US 2020/0157350 A1<br>examples 1-6, table 1<br>EP 3636715 A1<br>CN 110709474 A<br>KR 10-2020-0014327 A<br>TW 201905054 A | |
| CN 109504340 A | 22 March 2019 | (Family: none) | |
| CN 109504341 A | 22 March 2019 | (Family: none) | |
| CN 101985519 A | 16 March 2011 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019181713 A
- JP 2009179714 A
- JP 2016053140 A
- JP 2016079204 A
- WO 2019021824 A
- WO 2019021826 A